Europäisches Patentamt

European Patent Office

Office européen des brevets

(19)

(11) Veröffentlichungsnummer: **0 171 529**
**A2**

(12) # EUROPÄISCHE PATENTANMELDUNG

(21) Anmeldenummer: 85106766.0

(22) Anmeldetag: 01.06.85

(51) Int. Cl.⁴: **H 03 J 3/18**
**H 03 D 3/24**

(30) Priorität: 14.08.84 DE 3429868

(43) Veröffentlichungstag der Anmeldung:
19.02.86 Patentblatt 86/8

(84) Benannte Vertragsstaaten:
AT BE DE FR GB IT LU NL

(71) Anmelder: Blaupunkt-Werke GmbH
Robert-Bosch-Strasse 200
D-3200 Hildesheim(DE)

(72) Erfinder: Ohler, Michael, Dipl.-Ing.
In der Dehne 4
D-3211 Despetal(DE)

(74) Vertreter: Eilers, Norbert, Dipl.-Phys.
Blaupunkt-Werke GmbH Robert-Bosch-Strasse 200
D-3200 Hildesheim(DE)

(54) Abstimmbarer Resonanzkreis für einen PLL-FM-Demodulator.

(57) Bei einer Empfangsschaltung mit einem abstimmbaren Resonanzkreis für einen PLL-FM-Demodulator für das Satelliten-Fernsehen ist parallel zu zwei Abstimmdioden eine erste Induktivität angeordnet und über eine Kapazität mit Masse verbunden. An dem Masse abgewandten Ende der ersten Induktivität befindet sich eine zweite parallele Induktivität, deren Fußpunkt kapazitiv an Masse liegt und mit einer einstellbaren Vorspannung beaufschlagt ist.

Durch Veränderungen der beiden Induktivitäten und der Vorspannung läßt sich die Abstimmkennlinie des Resonanzkreises weitgehend linearisieren, um eine fehlerfreie Demodulation zu erzielen. Dabei kommt die erfindungsgemäße Schaltung mit wenigen preiswerten Bauteilen aus, so daß eine kostengünstige Serienproduktion möglich ist.

EP 0 171 529 A2

### Abstimmbarer Resonanzkreis für einen
### PLL-FM-Demodulator

Die Erfindung betrifft einen abstimmbaren Resonanzkreis
für einen PLL-FM-Demodulator zum Empfang von Satellitenprogrammen, insbesondere von Satelliten-Fernsehprogrammen, mit zwei in Reihe geschalteten Abstimmdioden, deren einander zugewandten gleichen Elektroden über einen
Mittenpunkt mit einer PLL-Regelschleife in Verbindung
stehen.

Es ist schon bekannt, bei der Übertragung von Programmen,
und hier insbesondere auch von Fernsehprogrammen, Satelliten einzusetzen, um größere Reichweiten zu erzielen
und größere Gebiete versorgen zu können. Vor allem das
Satellitenfernsehen gewinnt eine steigende Bedeutung,
und es ist davon auszugehen, daß mit der Möglichkeit
zunehmender - auch privater - Anbieter von Fernsehprogrammen und der Möglichkeit der Einspeisung in Kabelnetze ein wachsender Bedarf an entsprechenden Schaltungen besteht.

Das Satelliten-Fernsehen ist zwar an sich nicht mehr neu,
allerdings beschränkte sich die Ausnutzung und Anwendung
bisher zentral auf einige wenige Anstalten. Von der Technik her bedient man sich einer FM-Modulation mit der Möglichkeit einer PLL-Demodulation, weil dann bei den in Frage kommenden sehr hohen Frequenzen relativ geringe Leistungen ausreichend sind. Ein weiterer bedeutsamer Gesichtspunkt ist der Vorteil der PLL-Demodulation hinsichtlich des geringen Rauschverhaltens, was unter Berücksichtigung der relativ schwachen empfangenen Signale von Bedeutung ist.

Neben den voranstehend geschilderten Merkmalen ist empfangsseitig die Linearität der Abstimmkennlinie des PLL-FM-Demodulators ein entscheidendes und wichtiges Kriterium, um eine einwandfreie Demodulation zu gewährleisten. Wenn die Abstimmkennlinie des zugehörigen Resonanzkreises unzulässig gekrümmt verläuft, ergibt sich eine fehlerhafte Demodulation mit der Folge, daß auf dem Bildschirm eines angeschlossenen Fernsehgerätes der Bildinhalt sowohl bezüglich der Helligkeit als auch bezüglich der Farbwiedergabe gestört ist. Außerdem kommt es im Falle des Vorhandenseins von Tonträgern zu Intermodulationsstörungen. Grundsätzlich bereitet es keine Schwierigkeiten, die Abstimmkennlinie in gewünschter Weise weitgehend linear zu gestalten, allerdings ist dies mit einem erheblichen Mehraufwand bezüglich der Schaltungsmaßnahmen verbunden. Wie schon erwähnt, wird das Satelliten-Fernsehen bisher nur von wenigen Institutionen genutzt, welche jeweils nur eine Empfangsanlage benötigen, um das Programm anschließend an eine Vielzahl von Fernsehgeräten weiterzuleiten (z.B. über ein lokales Kabelnetz). Daher ist der Mehraufwand für solche professionelle Lösungen bisher auch vertretbar gewesen.

Mit der zunehmenden Bedeutung des Satelliten- und des Kabelfernsehens erhöht sich aber der Bedarf an den zur Rede stehenden abstimmbaren Resonanzkreisen, und es ist sogar denkbar, daß auch private Haushalte selbst mit einer eigenen Antenne die Satelliten-Fernsehprogramme empfangen können. Dann sind aber die teuren professionellen Lösungen mit den erheblichen Kosten für die Schaltung des Resonanzkreises mit einer weitgehend linearen Abstimmkennlinie ein Hemmnis.

Der Erfindung liegt die Aufgabe zugrunde, einen abstimmbaren Resonanzkreis der eingangs genannten Gattung zu schaffen, welcher mit einfachen und preiswerten Schaltungsmitteln eine weitgehend lineare Abstimmkennlinie ermöglicht.

Die Lösung dieser Aufgabe erfolgt bei dem im Oberbegriff des Anspruch 1 genannten abstimmbaren Resonanzkreis dadurch, daß parallel zu den beiden Abstimmdioden eine erste Induktivität angeordnet und über
eine Kapazität mit Masse verbunden ist, und daß an
dem Masse abgewandten Ende der ersten Induktivität
eine zweite parallele Induktivität vorgesehen ist,
deren Fußpunkt kapazitiv an Masse liegt und mit einer
einstellbaren Vorspannung beaufschlagt ist.

Der erfindungsgemäße Resonanzkreis benötigt nur überraschend wenige preiswerte Bauteile, und in praktischen
Versuchen konnte nachgewiesen werden, daß sich dennoch
eine lineare Abstimmkennlinie und eine fehlerfreie Demodulation erreichen läßt, und daß die vorgegebenen
Normen ohne weiteres eingehalten werden können. Wegen
der vergleichesweise niedrigen Gesamtkosten ermöglicht
daher die Erfindung hier erstmals eine wirtschaftliche
Serienproduktion.

Die erste parallele Induktivität, die über eine Kapazität
mit Masse verbunden ist, übernimmt bei der Erfindung
unter anderem die Funktion einer bei niedrigen Frequenzbereichen an sich bekannten Hubdehnungsspule, und außerdem bringt die erste Induktivität die beiden dem Mittenpunkt abgewandten gleichen Elektroden der Abstimmdioden galvanisch miteinander in Verbindung.

0171529

Die ebenfalls parallel angeordnete zweite Induktivität
bestimmt demgegenüber im wesentlichen die Frequenz
des Resonanzkreises, wobei diese Induktivität - ebenso wie die erste Induktivität - in zweckmäßiger Ausgestaltung der Erfindung als Luftspule ausgebildet
ist. Durch einfaches Spreizen oder Niederdrücken einzelner Windungen der Luftspulen lassen sich somit die
Induktivitätswerte verändern, um die Abstimmkennlinie
"abzugleichen" bzw. zu linearisieren. Hierbei kann gegebenenfalls auch noch der Wert der genannten Kapazität
verändert werden. Neben der Einstellung eines Bereiches
mit einer konstanten Abstimmsteilheit im Nutzfrequenzbereich ist durch die Veränderung der genannten Werte
darüberhinaus auch noch eine Korrektur von Streuungen
der beiden Abstimmdioden möglich, wenn die Induktivitäten
verändert werden.

Der Demodulator umfaßt auch ein aktives Element, damit
der Resonanzkreis schwingen kann, und gemäß einer zweckmäßigen Ausgestaltung der Erfindung ist das hierfür benötigte aktive Element Bestandteil einer an sich bekannten
integrierten Schaltung, die in Serienproduktion und
damit kostengünstig gefertigt wird. Eine solche integrierte Schaltung ist bisher bei den hier zur Rede
stehenden hohen Frequenzen nicht eingesetzt worden.

Andere vorteilhafte Weiterbildungen der Erfindung sind in den Unteransprüchen angegeben und der Zeichnung zu entnehmen.

Nachfolgend wird die Erfindung an Hand der Zeichnung beispielhaft näher erläutert. Es zeigen:

Fig. 1          ein Prinzip-Blockschaltbild einer Empfangsschaltung beim Satelliten-Fernsehen,

Fig. 2          ein Blockschaltbild eines in Fig. 1 verwendeten Demodulators,

Fig. 3          ein Schaltbild eines abstimmbaren Resonanzkreises gemäß der Erfindung, und

Fig. 4          ein Diagramm mit einer Abstimmkennlinie.

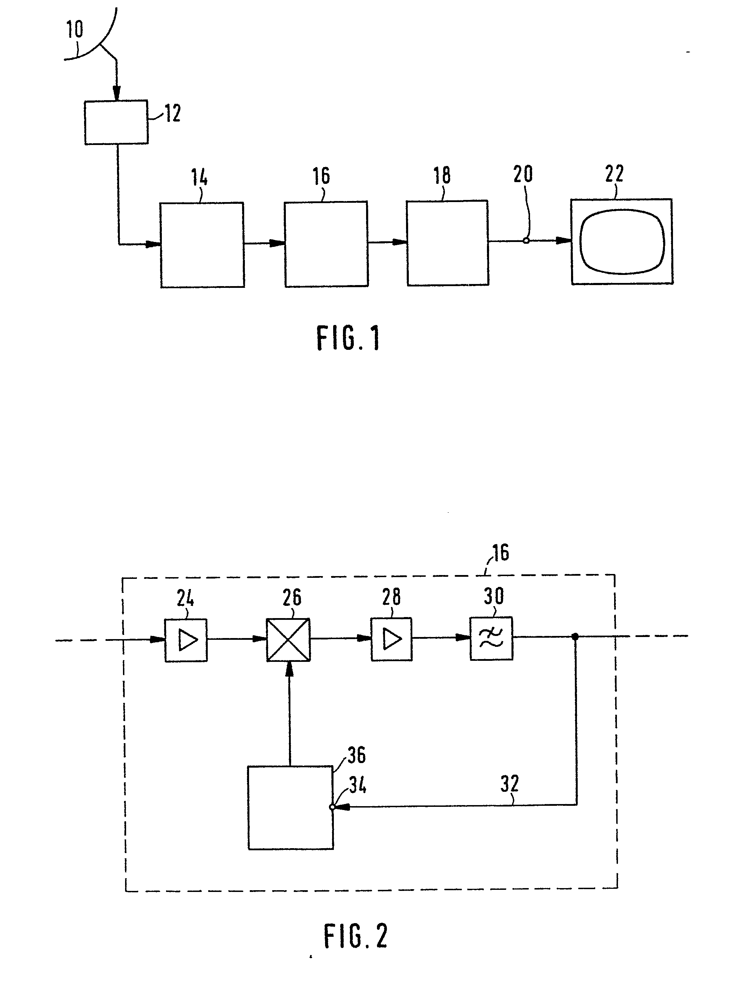

In Fig. 1 werden die von einem nicht dargestellten Satelliten ausgestrahlten Signale von einer Parabol-Antenne 10 empfangen, an die sich ein Umsetzer 12 anschließt.

Die Empfangsfrequenz liegt hier bei 12 GHz, welche
mittels des Umsetzers 12 in eine erste Zwischenfrequenz
von 950-1750 MHz umgesetzt wird.

In einem Kanalwähler 14 erfolgt eine weitere Frequenzumsetzung auf eine zweite Zwischenfrequenz von 480 MHz.
An den Kanalwähler 14 schließt sich ein Demodulator 16
an, und von hier aus gelangen die demodulierten Signale zu einer Video-Verarbeitungsschaltung 18.

Am Ausgang der Video-Verarbeitungsschaltung 18 stehen
an einer Schnittstelle 20 Signale zur Verfügung, um
ein Fernsehgerät 22 zu speisen. An der Schnittstelle 20
kann auch die Einspeisung in ein nicht dargestelltes
Kabelnetz erfolgen, um eine Vielzahl von Fernsehgeräten zu versorgen.

In Fig. 2 ist der nähere Aufbau des Demodulators 16
gezeigt. Von einem Verstärker 24 gelangt die zweite
Zwischenfrequenz zu einem Phasendetektor 26 dem sich
ein weiterer Verstärker 28 und ein Frequenzfilter 30
anschließen.

In an sich bekannter Weise umfaßt der Demodulator 16
eine PLL-Regelschleife 32, die von dem Frequenzfilter 30 zu einem Rückkopplungseingang 34 eines spannungsgesteuerten Oszillators (VCO) 36 führt.Letzterer ist mit dem
Phasendetektor 26 verbunden, wodurch der Regelkreis
geschlossen wird.

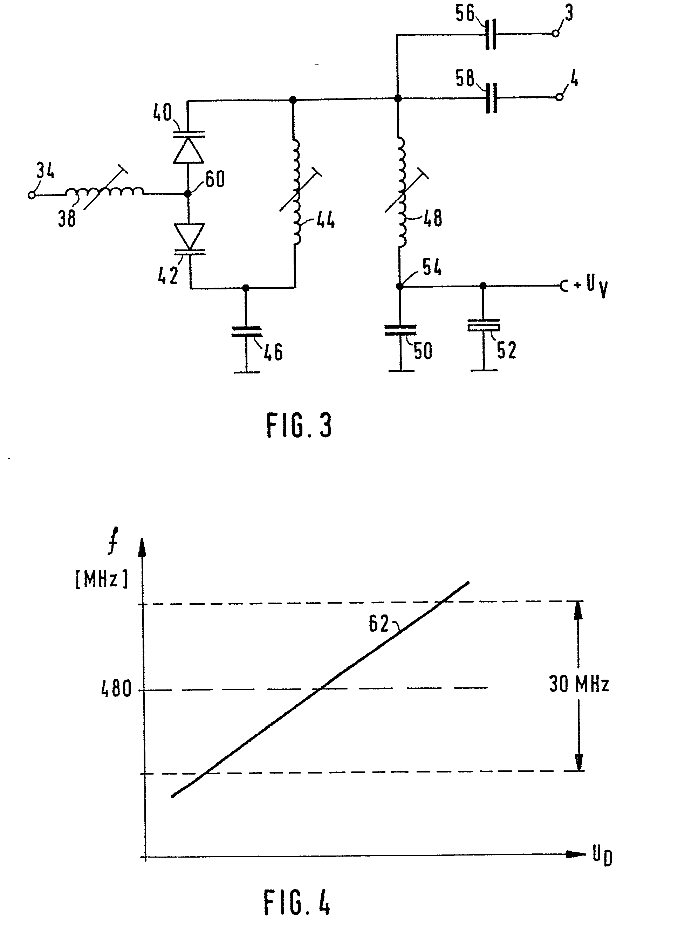

Die Oszillatorschaltung 36 umfaßt neben einem aktiven
Element einen abstimmbaren Resonanzkreis, dessen Aufbau in Fig. 3 dargestellt ist. An dem schon genannten
Rückkopplungseingang 34 liegt ein Regelsignal an,
welches über eine Entkopplungsinduktivität 38 zu einem
Mittenpunkt 60 gelangt, welcher die Anoden der beiden
Abstimmdioden 40 und 42 miteinander verbindet.

Parallel zu den Abstimmdioden 40, 42 ist eine erste
Induktivität 44 angeordnet, welche über eine Kapazität
46 an Masse liegt. Ferner ist eine zweite Induktivität
48 vorgesehen, an deren Fußpunkt 54 eine positive Vorspannung $U_V$ liegt. Außerdem ist der Fußpunkt 54 über
eine relativ geringe Kapazität 50 und eine dazu parallel
geschaltete relativ große Kapazität 52 mit Masse verbunden.

Mit den Bezugsziffern 3 und 4 sind die so nummerierten
Anschlüsse einer integrierten Schaltung vom Typ TUA 2000
bezeichnet, welches das benötigte aktive Element für

0171529

den Resonanzkreis beinhaltet. Wie man erkennen kann,
sind die oberen Enden der ersten Iduktivität 44 und
der zweiten Induktivität 48 jeweils über eine Kapazität 56 und 58 mit der genannten integrierten Schaltung verbunden.

Fig. 4 zeigt in einer graphischen Darstellung eine
ideale lineare Abstimmkennlinie 62, wobei die Mittenfrequenz des Resonanzkreises bei 480 MHz liegt. Um
eine optimale Demodulation zu erzielen, ist die Abstimmkennlinie 62 in einem Bereich von 30 MHz weitgehend linear ausgebildet.

Auf der unteren waagerechten Achse in Fig. 4 ist eine
Differenzspannung $U_D$ aufgetragen, welche als Differenz
der schon erwähnten positiven Vorspannung $U_V$ und der
Spannung am Mittenpunkt 60 den Arbeitsbereich der
beiden Abstimmdioden 40 und 42 festlegt und einstellt.
Durch entsprechende Wahl der positiven Vorspannung $U_V$
am Fußpunkt der zweiten Induktivitär 48 läßt sich
also der Arbeitsbereich beeinflussen, um in Fig. 4
einen Bereich mit konstanter Abstimmsteilheit zu erzielen.

In dem gezeigten Ausführungsbeispiel sind die Anoden der beiden Abstimmdioden 40 und 42 über den Mittenpunkt
60 miteinander verbunden, und es ist eine positive Vorspannung $U_V$ vorgesehen. Es können aber auch Abstimmdioden in umgekehrter Polarität vorgesehen werden (hier sind
die Kathoden über den Mittenpunkt 60 miteinander verbunden), und es ist dann erforderlich, die Vorspannung $U_V$
negativ (bezogen auf den Mittenpunkt 60) zu wählen.

Die beiden Kapazitäten 50 und 52 schließen den Fußpunkt
54 der zweiten Induktivität 48 hochfrequenzmäßig kurz.
Damit dieser Kurzschluß auch in weiten Frequenzbereichen
wirksam ist (z.B. auch für Video-Frequenzen), besitzt
die eine Kapazität 50 einen relativ geringen und die
andere parallele Kapazität 52 einen relativ großen
Wert.

Die verwendeten Induktivitäten 38, 44 und 48 sind einstellbare Induktivitäten und als Luftspulen ausgebildet. Hierbei kann eine Veränderung der Induktivitätswerte in einfacher Weise durch ein Spreizen oder Niederdrücken einzelner Windungen der Luftspule erfolgen. Dabei läßt sich durch Veränderungen der Induktivität 48
die Abstimmkennlinie 62 in eine gewünschte Lage bezogen auf die Mittenfrequenz des Resonanzkreises bringen.
Die Steilheit der Abstimmkennlinie 62 kann durch Veränderungen der Werte der Induktivität 44 bewirkt werden.
Zusätzlich läßt sich durch die an sich bekannte Entkopplungsinduktivität 38 bzw. durch Änderungen des Induktivitätswertes eine weitere Linearisierung der Abstimmkennlinie 62 erzielen. Die für die Einstellung des Arbeitsbereiches der beiden Abstimmdioden 40 und 42 benötigte Vorspannung läßt sich übrigens in zweckmäßiger
Weise dem Kanalwähler 14 entnehmen, so daß eine gesonderte Spannungsquelle nicht erforderlich ist.

Die Erfindung ermöglicht eine kostengünstige Auslegung
des Verstärkers 28, da auf einen teuren Operationsverstärker mit hoher Grenzfrequenz (mit der Notwendigkeit einer zusätzlichen negativen Versorgungsspannung)
verzichtet werden kann.

Ein weiterer Vorteil der Erfindung besteht in der Möglichkeit der Verwendung der schon genannten integrierten
Schaltung TUA 2000, dessen aktives Element für den spannungsgesteuerten Oszillator 36 herangezogen wird. Es
handelt sich hierbei um einen bekannten Konsumer-IC, der
bisher im VHF-Tuner verwendet wurde und bei der Erfindung
ein neues Einsatzgebiet findet, denn in Verbindung mit
einer PLL-Regelschleife ist dieser IC bisher nicht eingesetzt worden. Die Verwendung des bekannten IC's trägt
neben weiteren Merkmalen der Erfindung erheblich dazu bei,
daß der neuartige Resonanzkreis preisgünstig in einer

0171529 -

Serienproduktion hergestellt werden kann.

Erfindungsmeldung-Nr. 33/84                    200/18


                    P a t e n t a n s p r ü c h e
          ==================================


1.      Abstimmbarer Resonanzkreis für einen PLL-FM-Demodulator zum Empfang von Satellitenprogrammen, insbesondere von Satelliten-Fernsehprogrammen, mit zwei in Reihe geschalteten Abstimmdioden, deren einander zugewandten gleichen Elektroden über einen Mittenpunkt mit einer PLL-Regelschleife in Verbindung stehen, dadurch gekennzeichnet, daß parallel zu den beiden Abstimmdioden (40, 42) eine erste Induktivität (44) angeordnet und über eine Kapazität (46) mit Masse verbunden ist, und daß an dem Masse abgewandten Ende der ersten Induktivität (44) eine zweite parallele Induktivität (48) vorgesehen ist, deren Fußpunkt (54) kapazitiv (50; 52) an Masse liegt und mit einer einstellbaren Vorspannung ($U_V$) be-

aufschlagt ist.

2.      Resonanzkreis nach Anspruch 1, dadurch gekennzeichnet, daß der Fußpunkt (54) der zweiten Induktivität
(48) über eine Parallelschaltung einer ersten (50) relativ kleinen und einer zweiten relativ großen Kapazität (52) mit Masse verbunden ist.

3.      Resonanzkreis nach Anspruch 1 oder 2, dadurch
gekennzeichnet, daß an den Mittenpunkt (60) der Abstimmdioden (40, 42) eine Entkopplungsinduktivität (38) angeschlossen ist.

4.      Resonanzkreis nach einem der vorhergehenden Ansprüche 1 - 3, dadurch gekennzeichnet, daß die Entkopplungsinduktivität (38) sowie die erste (44) und zweite
Induktivität (48) durch Luftspulen gebildet sind.

5.      Resonanzkreis nach einem der vorhergehenden Ansprüche 1 - 4, dadurch gekennzeichnet, daß die Entkopplungsinduktivität (38) sowie die erste (44) und zweite
Induktivität (48) einstellbare Induktivitäten sind.

6.      Resonanzkreis nach einem der vorhergehenden Ansprüche 1 - 5, dadurch gekennzeichnet, daß der Mittenpunkt (60) die beiden Anoden der beiden Abstimmdioden (40, 42) miteinander verbindet, und daß die Vorspannung ($U_V$) in Bezug auf den Mittenpunkt (60) positiv ist.

7.    Resonanzkreis nach einem der vorhergehenden Ansprüche 1 - 5, dadurch gekennzeichnet, daß der Mittenpunkt (60) die beiden Kathoden der Abstimmdioden (40, 42) miteinander verbindet, und daß die Vorspannung ($U_V$) in Bezug auf den Mittenpunkt (60) negativ ist.

8.    Resonanzkreis nach einem der vorhergehenden Ansprüche 1 - 7, dadurch gekennzeichnet, daß er an ein aktives Element angekoppelt (3, 4) ist, welches Bestandteil einer integrierten Schaltung ist.

9.    Resonanzkreis nach einem der vorhergehenden Ansprüche 1 - 8, dadurch gekennzeichnet, daß seine Mittenfrequenz bei 480 MHz liegt.

FIG.1

FIG.2

FIG. 3

FIG. 4